# EUROPEAN PATENT APPLICATION

(11) **EP 2 224 492 A2**
(43) Date of publication of application: **01.09.2010**
(21) Application number: 10001909.0
(22) Date of filing: 24.02.2010
(51) Int. Cl.: H01L 31/0224

(54) **Solar cell and method for fabricating the same**

(30) Priority: 25.02.2009 US 155162 P
(71) Applicant: DelSolar (Wujiang) Ltd., Economics Development Zone Wujiang City, Jiang Su Province (CN); DelSolar Co., Ltd., Hsinchu (TW)
(72) Inventor: Wang, Pin-Sheng, Jhubei City Hsinchu County (TW); Chou, Yi-Chin, Shengang Township Changhua County (TW); Lin, Shih-Cheng, Jhudong Township Hsinchu County (TW); Huang, Shih-Yu, Jhonghe City Taipei County (TW); Tu, Chia-Chen, Fongyuan Cita Taichung County (TW)
(74) Representative: Hager, Thomas Johannes

(57) **Abstract**

A high-efficiency solar cell structure enables high throughput manufacturing process thereof. The solar cell (10, 20, 30) is accomplished by forming a plurality of first emitter regions (12, 22, 32) in a front surface of a substrate (11, 21, 31), a plurality of second emitter regions (13, 23, 33) in the front surface, and a plurality of fingers (14, 24, 34). Each of the fingers (14, 24, 34) is formed over a least a portion of the second emitter regions (13, 23, 33) and a portion of the first emitter regions (12, 22, 32). The first emitter regions (12, 22, 32) and the second emitter regions (13, 23, 33) have a depth not less than 0.2 µm.

## Description

The present invention relates to a crystalline solar cell and a fabricating method according to the pre-characterizing clauses of claim 1 and 7.

An optimized emitter design has to consider two different areas on the surface of a so-called selective emitter solar cell: the area under the fingers and the area between the fingers. In order to reduce the electron-hole recombination effect in the area between the fingers, relatively higher surface resistance emitters are applied, while a relatively lower surface resistance is provided directly under each finger.

The advantages of having two different regions in the pn-junction are well understood, in that higher Isc, Voc and improved FF can result from a lower electron-hole recombination effect near the surface of semiconductor substrate.

In addition, the width of the emitter region under each finger is made as narrow as possible (preferably 30 to 60 µm) in order to reduce the possibility of electron-hole recombination, and the depth of the emitter region between two fingers is made as shallow as possible (no greater than 2µm) in order to gain a better response in the near UV area. For the emitter profile described above, the fingers are highly aligned in order to prevent a short circuit during metallization.

To fabricate such a solar cell, the fingers need to be formed by a costly and complicated process wherein highly precise alignment is required.

This in mind, the present invention aims at providing a silicon solar cell and a fabricating method that is cost effective.

This is achieved by a silicon solar cell and a fabricating method according to claims 1 and 7. The dependent claims pertain to corresponding further developments and improvements.

As will be seen more clearly from the following detailed description below, the claimed silicon solar cell and the fabricating method includes fabricating the front side of the solar cell by a screen printing process.

In the following, the invention is further illustrated by way of example, taking reference to the accompanying drawings. Thereof:
Figs. 1a-1c show three exemplary solar cell structures according to preferred embodiments of the present invention;
Fig. 2 shows a process flow for fabricating a solar cell having the feature that the N+ diffusion area is formed before the formation of the N- diffusion area;
Fig. 3 shows a process flow for fabricating the solar cell having the feature that the N-diffusion area is formed before the formation of the N+ diffusion area; and
Fig. 4 shows a process flow for fabricating the solar cell having the feature that the N- and N+ diffusion areas are formed at the same time.

The present invention pertains to a high-efficiency solar cell with a simplified structure, which enables a high throughput manufacturing process thereof.

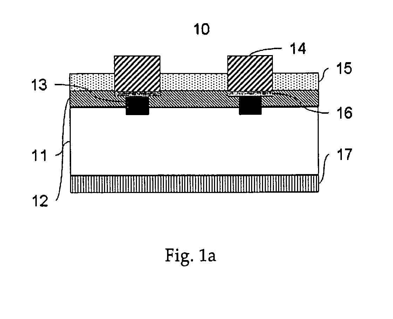

As shown in Figs. 1a-1c, from one aspect, the invention provides a solar cell (10, 20, 30) comprising (i) a semiconductor substrate (11, 21, 31), (ii) a plurality of first emitter regions (12, 22, 32) formed in a front surface of the semiconductor substrate (11, 21 ,31), (iii) a plurality of second emitter regions (13, 23, 33) formed in the same surface with the first emitter regions, (iv) a field region (17, 27, 37) formed in the opposite surface of the semiconductor substrate, (v) a plurality of fingers (14, 24, 34), each of which is formed over at least a portion of the second emitter region (13, 23, 33) and a portion of the first emitter regions (12, 22, 32), and (vi) a plurality of metal-semiconductor contact (MSC) (16, 26, 36), which provide good ohmic contact between the fingers (14, 24, 34), first emitter regions (12, 22, 32) and second emitter regions (13, 23, 33). The first emitter regions (12, 22, 32) and second emitter regions (13, 23, 33) are interspersed in the front surface of the semiconductor substrate (11, 21, 31). The semiconductor substrate (11, 21, 31) preferably comprises p-type doped silicon, and the first emitter regions (12, 22, 32) and second emitter regions (13, 23, 33) are preferably formed by doping an n-type material, such as phosphorous. The field region (17, 27, 37) is preferably formed by doping a p-type dopant material comprising, for example, pure aluminum or an alloy of aluminum and silicon.

The surface resistance of the first emitter regions (12, 22, 32) is in the range of 80 ohms/square to 400 ohms/square, and preferably in the range from about 90 ohms/square to about 180 ohms/square. The surface resistance of the second emitter regions (13, 23, 33) is in the range from about 5 ohms/square to 80 ohms/square, and preferably in the range from about 20 ohms/square to about 60 ohms/square.

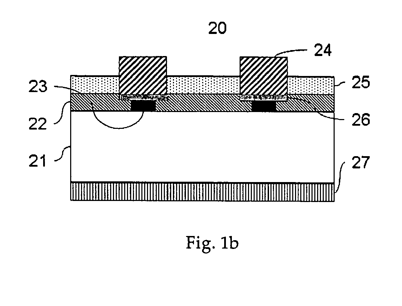

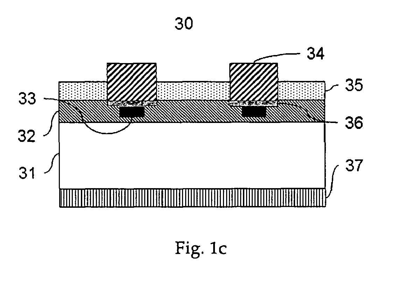

Furthermore, the depths of the first emitter regions (12, 22, 32) and second emitter regions (13, 23, 33) are both preferably not less than about 0.2 µm and the relation between the depth of the first emitter regions (12, 22, 32) and second emitter regions (13, 23, 33) can be any of the following conditions: (i) the depth of the first emitter regions (12) is less than the depth of the second emitter regions (13) as shown in Fig. 1a ; (ii) the depth of the first emitter regions (22) is similar to the depth of the second emitter regions (23) as shown in Fig. 1b; and (iii) the depth of the first emitter regions (32) is greater than the depth of the second emitter regions (33) as shown in Fig. 1c. The configuration as shown in Fig. 1 a is a preferred embodiment. Preferably, the depth of the first emitter regions (12) is less than the depth of the second emitter regions (13).

The solar cell is further preferably provided with an antireflective layer (15, 25, 35) formed over the same surface as the first emitter regions (12, 22, 32) and second emitter regions (13, 23, 33) of the semiconductor substrate.

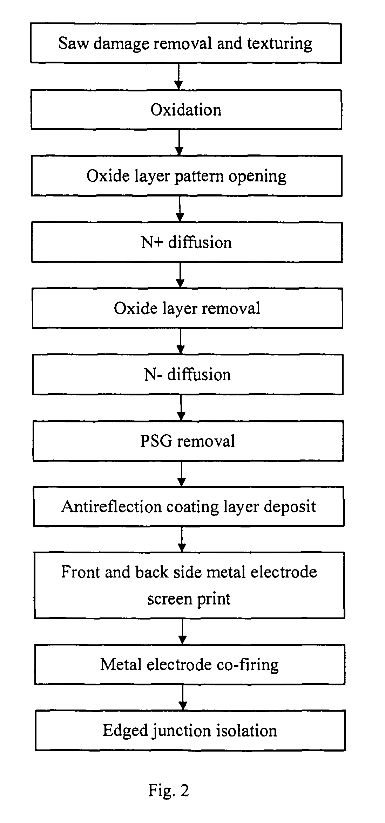

As shown in Figs. 2 - 4, from a process aspect, the invention provides a method of fabricating a solar cell having a plurality of fingers (14), each of which is formed over at least a portion of the second emitter region (13) and a portion of the first emitter region (12). The method includes the steps of: providing a semiconductor substrate (11), forming a plurality of first emitter regions (12), forming a plurality of second emitter regions (13) in the same surface as the first emitter regions (12), forming a field region (17) in the opposite surface of the semiconductor substrate (11), forming an oxide layer on the same surface as the first and second emitter regions, removing the oxide layer, printing a metal paste covering over at least a portion of the second emitter regions and a portion of the first emitter regions, and heating the semiconductor substrate (11) for a sufficient period of time to form a plurality of fingers (14) and a plurality of MSC (16).

The oxide layer is formed over the surface of the semiconductor substrate (11) at a high temperature in an oxygen-rich environment and is then removed before the step of metallization.

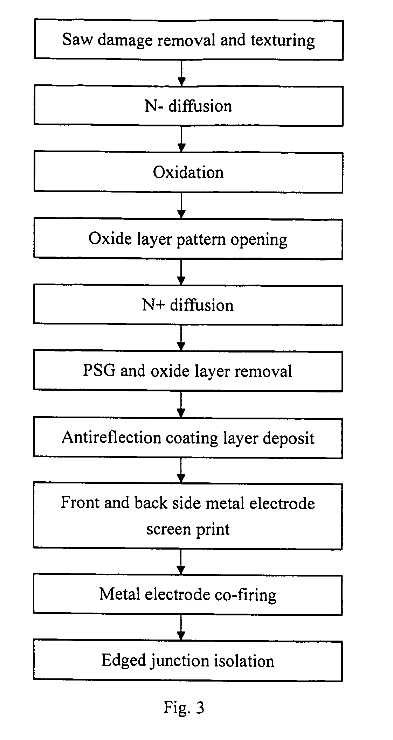

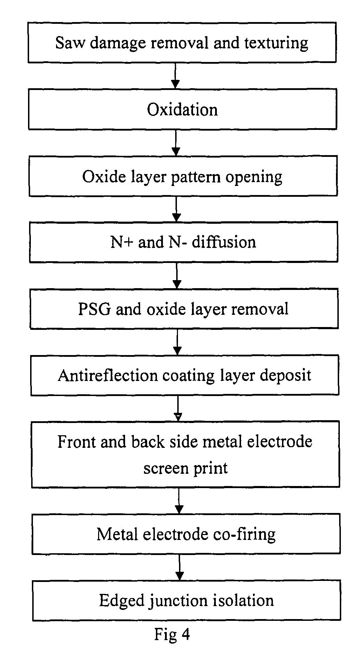

The steps of forming the first and second emitter regions (12, 13) can be conducted under any of the following conditions: (i) the step of forming first emitter regions (12) is prior to the step of forming second emitter regions (13) as shown in Fig. 3; (ii) the step of forming first emitter regions (12) is performed after the step of forming second emitter regions (13) as shown in Fig. 2; (iii) the first emitter regions (12) and the second emitter regions (13) are formed substantially at the same time as shown in Fig. 4.

Furthermore, the location of the second emitter regions (13) is designed by oblation of a predetermined portion of the oxide layer by methods including, but not limited to, (i) etching paste;(ii) photolithography; (iii) inkjet printing, and (iv) laser.

The semiconductor substrate (11) is preferably doped by p-type materials and having a surface resistance ranging from approximately 0.5 ohms/square to 6 ohms/square. The first and second emitter regions (12, 13) are preferably formed using n-type dopant material, while the field region (17) in the opposite surface of the semiconductor substrate is formed. The finger (14) is formed over the second emitter regions (13) and a portion of the first emitter regions (11) by depositing the metal paste. Options for the metal paste include, but are not limited to, DuPont PV series, FERRO 33-462, Heraeus SOL-9118A, and Noritake NP-4682C.

Upon completion of the first emitter regions (12), the first emitter regions (12) will have a depth not less than about 0.2 µm and a surface resistance in a range of 80 to 400 ohms/square and preferably in the range from about 90 ohms/square to about 180 ohms/square.

Upon completion of the second emitter regions (13), the second emitter regions (13) will have a depth not less than about 0.2µm and a surface resistance of the range from about 5 ohms/square to about 80 ohms/square and preferably in the range from about 20 ohms/square to about 60 ohms/square.

The step of fingers (14) and the MSC (14) is conducted by depositing a metal paste to cover the second emitter regions and a portion of the first emitter regions by any of the following methods: screen printing, transfer coating, printing, thermal inkjet printing, electro-deposition, electroless plating, or electroplating. Heating the semiconductor substrate (11) at 350∼950 C° for a sufficient time is followed by depositing the metal paste as described above.

The invention provides a number of advantages over the prior art solar cells and the manufacturing methods thereof. The combination of lower surface resistance regions and higher surface resistance regions in the p-n junction of the solar cell acts minimizes the electron-hole recombination effect. The tolerance of the fingers covering a portion of first emitter regions results in a lower cost and high throughput process that can be used, for example, in the existing screen printing process.

All combinations and sub-combinations of the above-described features also belong to the invention. Cross Reference To Related Applications

This application claims priority benefit of U.S. Provisional Patent Application Serial No. 61/155,162, filed on February 25th, 2009.

## Claims

1. A crystalline silicon solar cell (10, 20, 30), **characterized by**:
a plurality of first emitter regions (12, 22, 32) formed in a front surface of said solar cell (10,20,30) with a relatively higher surface resistance;
a plurality of second emitter regions (13, 23, 33) formed in said front surface with a relatively lower surface resistance; and
a plurality of fingers (14, 24, 34) each of which is formed over at least a portion of said second emitter regions (13, 23, 33) and a portion of said first emitter regions (12, 22, 32).

2. The crystalline silicon solar cell according to claim 1 **characterized in that** said first emitter regions (12, 22, 32) have a depth not less than 0.2 µm; or
that said second emitter regions (13, 23, 33) have a depth not less than 0.2 µm.

3. The crystalline silicon solar cell according to claim 1 **characterized in that** said relatively higher surface resistance of said first emitter regions (12, 22, 32) is in the range from approximately 80 to 400 ohms/square; in particular
that said relatively higher surface resistance of said first emitter regions (12, 22, 32) is in the range of from approximately 90 to 180 ohms/square.

4. The crystalline silicon solar cell according to claim 1 **characterized in that** said relatively lower surface resistance of said second emitter regions (13, 23, 33) is in the range from approximately 5 to 80 ohms/square; in particular
that said relatively lower surface resistance of said second emitter regions (13, 23, 33) is in the range from approximately 20 to 60 ohms/square.

5. The crystalline silicon solar cell according to claim 1 **characterized in that** a width of each of said fingers (14, 24, 34) is not less than a width of each of said second emitter regions (13, 23, 33).

6. The crystalline silicon solar cell according to claim 1 **characterized in that** said fingers (14, 24, 34) are formed by depositing a metal over a semiconductor surface (11, 21, 31) by a method selected from a group consisting of: (1) screen printing, (2) transfer coating, (3) printing, (4) thermal inkjet printing, (5) electro-deposition, (6) electroless plating, and (7) electroplating; in particular
that said metal comprises silver; or
that said metal comprises silver paste; in particular
that said silver paste comprises DuPont PV145, PV159, FERRO 33-462, Heraeus OL-9118A or Noritake NP-4682C.

7. A method for fabricating a crystalline solar cell (10, 20, 30), **characterized by**:
providing a semiconductor substrate (11, 21, 31);
forming a plurality of first emitter regions (12, 22, 32) in a front surface of said semiconductor substrate (11, 21, 31);
forming a plurality of second emitter regions (13, 23, 33)in said front surface of said semiconductor substrate (11, 21, 31);
forming an oxide layer onto said front surface of said semiconductor substrate (11, 21, 31); and
forming a plurality of fingers (14, 24, 34) covering at least a portion of said second emitter regions (13, 23, 33) and a portion of said first emitter regions (12, 22, 32).

8. The method according to claim 7 **characterized in that** said oxide layer is removed before forming said plurality of fingers (14, 24, 34).

9. The method according to claim 7 **characterized in that** said first emitter regions (12, 22, 32 ) have a depth not less than 0.2 µm; or that said second emitter regions (13, 23, 33) have a depth not less than 0.2 µm,

10. The method according to claim 7 **characterized in that** said first emitter regions (12, 22, 32) have a surface resistance in the range from approximately 80 to 400 ohms/square; in particular
that said first emitter regions (12, 22, 32) have a surface resistance in the range of from approximately 90 to 180 ohms/square.

11. The method according to claim 7 **characterized in that** said second emitter regions (13, 23, 33) have a surface resistance in the range from approximately 5 to 80 ohms/square; in particular
that said second emitter regions (13, 23, 33) have a surface resistance in the range from approximately 20 to 60 ohms/square.

12. The method according to claim 7 **characterized in that** said first emitter regions (12, 22, 32) and said second emitter regions (13, 23, 33) are interspersed in said front surface of said semiconductor substrate (11, 21, 31).

13. The method according to claim 7 **characterized in that** said second emitter regions (13, 23, 33) are conducted by oblation of a predetermined portion of said oxide layer by a method selected from a group consisting of: (1) etching paste; (2) photolithography; (3) inkjet printing and (4) laser.

14. The method according to claim 7 **characterized in that** said fingers (14, 24, 34) are formed by depositing metal paste on said front surface of said semiconductor substrate (11, 21, 31); or
that said fingers (14, 24, 34) are formed by heating said semiconductor substrate (11, 21, 31) for a duration in a temperature of about 700-950 □.

15. The method according to claim 7 **characterized in that** a width of each of said fingers (14, 24, 34) is not less than a width of each of said second emitter regions (13, 23, 33); and/or
that said metal paste comprises DuPont PV145, PV159, FERRO 33-462, Heraeus SOL-9118A and Noritake NP-4682C.
